(19) Europäisches Patentamt
European Patent Office
Office européen des brevets

(11) **EP 4 047 381 A1**

(12) **EUROPEAN PATENT APPLICATION**

(43) Date of publication:
**24.08.2022 Bulletin 2022/34**

(21) Application number: **22156496.6**

(22) Date of filing: **14.02.2022**

(51) International Patent Classification (IPC):
**G01R 35/00** (2006.01)  **H01L 23/08** (2006.01)
**G01R 1/20** (2006.01)  **G01R 3/00** (2006.01)
**G01R 15/20** (2006.01)  **H01L 43/14** (2006.01)

(52) Cooperative Patent Classification (CPC):
**G01R 35/007; H01L 23/057; H01L 23/08;**
**H01L 23/10;** G01R 1/203; G01R 3/00;
G01R 15/202; H01L 43/14

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **15.02.2021 KR 20210019796**

(71) Applicant: **Korea Research Institute of Standards**
**and Science**
**Daejeon 34113 (KR)**

(72) Inventors:
• **PARK, Jaesung**
  **34119 Daejeon (KR)**
• **LIM, Kyung-Geun**
  **47872 Busan (KR)**
• **CHAE, Dong-Hun**
  **34094 Daejeon (KR)**

(74) Representative: **Behr, Wolfgang**
**Lorenz Seidler Gossel**
**Rechtsanwälte Patentanwälte**
**Partnerschaft mbB**
**Widenmayerstraße 23**
**80538 München (DE)**

(54) **ENCAPSULATED STRUCTURE FOR QUANTUM RESISTANCE STANDARD**

(57)     An encapsulated structure (1000) for a quantum resistance standard according to an embodiment of the present invention includes a base (100); an object (200) disposed on the base and providing a measurement value of the quantum Hall resistance; two or more conductive lines (300) connected to the object on one end; and a cap (400) isolating the object from outside air.

FIG. 1

## Description

[Technical Field]

The present invention relates to an encapsulated structure for a quantum resistance standard, and more particularly, to an encapsulated structure for a quantum resistance standard having a long-term measurement stability by encapsulating a measurement object of a quantum Hall resistance.

[Background Art]

The quantum Hall effect is a phenomenon in which a Hall resistance has a certain value independent of a material under a specific condition and in which basic physical constant values of electron charge (e) and Planck's constant (h) appear as macroscopic measurement values that are called voltage.

In the normal Hall effect where electric field (E) is generated in a direction perpendicular to current (i) and magnetic field, a Hall conductivity i/E changes in inverse proportion to the magnetic field. In this regard, when a semiconductor device capable of confining electrons in a two-dimensional surface flows a current (i) to a sample surface at a temperature equal to or lower than 1K and applies a magnetic field perpendicular to a direction of the current, a flat stairs shape is obtained where the Hall conductivity is an integer multiple of $\frac{e^2}{h}$ . This is the quantum Hall effect.

The quantum Hall effect is related to the fact that if a bunch of electrons quantized to the Landau level by the magnetic field is concentrated in one place due to impurities in a semiconductor, the electrons may not contribute to the current.

The quantum Hall effect plays a key role in realizing the resistance standard by using a fixed value of a basic constant in the new International System of Units (SI) scheme that came into force in 2019.

Many metrology institutions realize a quantum ohm based on the quantum Hall resistance (QHR) of $\frac{h}{2e^2}$ with respect to a filling factor of 2 of the GaAs/Al-GaAs heterostructure. However, this realization requires a temperature of less than 1.5 K and a magnetic field of about 10 T due to a small Landau energy gap of GaAs.

In contrast, graphene exhibits the quantum Hall effect at a relatively high temperature and low magnetic field because the graphene has a large energy gap between Landau levels. It is useful to measure the quantized Hall resistance of graphene under relaxed experimental conditions, but there is a problem in that when the graphene is exposed to air, the graphene comes into contact with moisture, oxygen, and carbon impurities, and the quantum Hall resistance changes, making it impossible to use as the standard resistance.

[Disclosure]

[Technical Problem]

An object of the present invention is to provide an encapsulated structure capable of maintaining stability of a measurement object for a long time in measurement of a quantum Hall resistance for realization of a quantum resistance standard.

[Technical Solution]

In one general aspect, an encapsulated structure for a quantum resistance standard includes a base; an object disposed on the base and providing a measurement value of the quantum Hall resistance; two or more conductive lines connected to the object on one end; and a cap isolating the object from outside air.

The object may include graphene.

The graphene may correspond to epitaxial graphene grown on the base.

The cap may include a concave portion recessed in a certain area of one surface and a flat area of the one surface except for the certain area in which the concave portion is formed, and an adhesive layer may be interposed between the flat area and the base when the object is accommodated in the concave portion.

The cap may be formed of glass.

The adhesive layer may be formed of epoxy.

[Advantageous Effects]

The encapsulated structure for the quantum resistance standard according to the present invention maintains the quantum Hall resistance measurement value despite a thermal change between cryogenic and room temperatures according to the quantum Hall resistance measurement and the exposure environment of humidity of 90%, that is, has the same long-term stability within a measurement uncertainty of about 3 in a billion.

The effects obtainable in the present invention are not limited to the above-mentioned effects, and other effects not mentioned may be clearly understood by those of ordinary skill in the art to which the present invention belongs from the following description.

[Description of Drawings]

FIG. 1 is an exploded perspective view of an encapsulated structure for a quantum resistance standard according to an embodiment of the present invention.

FIG. 2 is a cross-sectional view of an encapsulated structure for a quantum resistance standard according to an embodiment of the present invention.
FIG. 3 is a flowchart of a method of manufacturing an encapsulated structure for a quantum resistance standard according to an embodiment of the present invention.

[Best Mode]

Hereinafter, the present invention will be described in detail with reference to the accompanying drawings.

The terms used in this specification are terms defined in consideration of the functions of the present invention, which may vary according to the intention or custom of the user or operator. Therefore, definitions of these terms should be made based on the description throughout this specification.

In addition, the embodiments disclosed below do not limit the scope of the present invention, but are merely exemplary matters of the components presented in the claims of the present invention, and are included in the technical spirit throughout the specification of the present invention and embodiments that are included in the technical spirit throughout the specification of the present invention and that include substitutable components as equivalents in the components of the claims may be included in the scope of the present invention.

In the embodiments disclosed below, the terms such as 'first', 'second', 'one surface', 'the other surface', etc. are used to distinguish one component from other components, and the componentsare not limited by the terms. Hereinafter, in describing the present invention, detailed descriptions of known technologies that may obscure the subject matter of the present invention will be omitted.

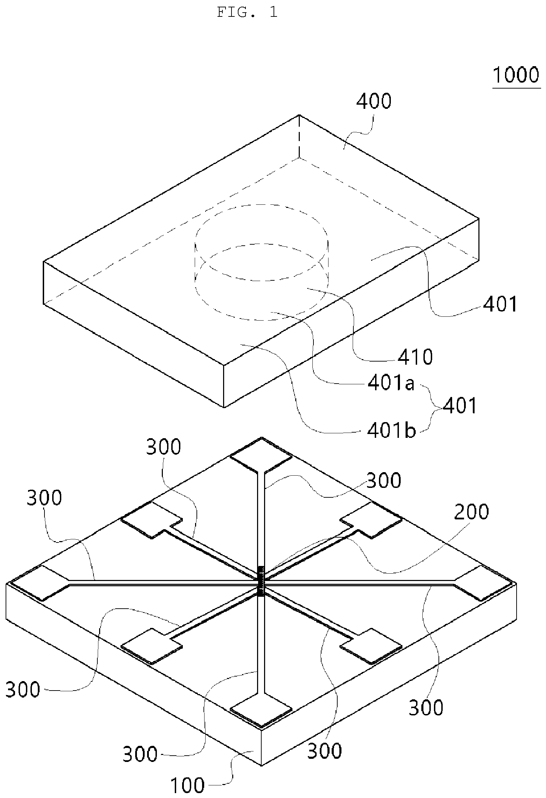

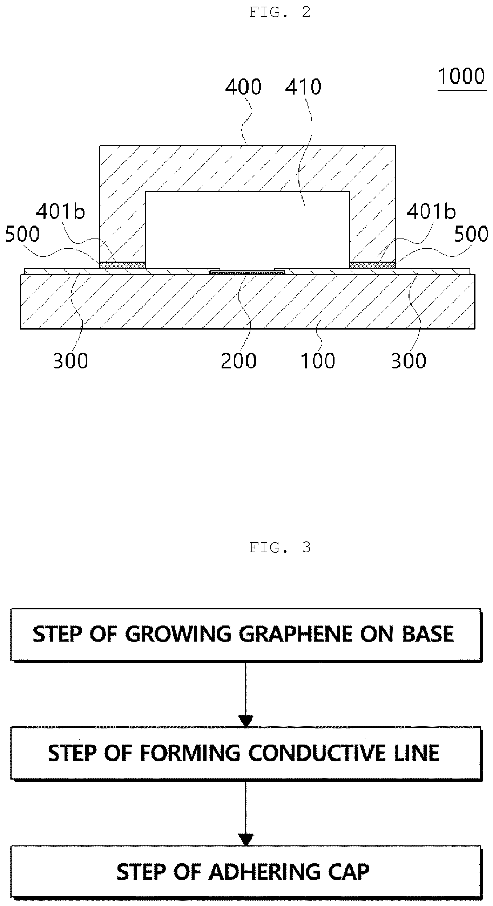

FIGS. 1 and 2 are respectively an exploded perspective view and a cross-sectional view of an encapsulated structure for a quantum resistance standard according to an embodiment of the present invention.

Referring to FIGS. 1 and 2, an encapsulated structure 1000 for the quantum resistance standard according to an embodiment of the present invention includes a base 100, an object 200, a conductive line 300, a cap 400, and an adhesive layer 500. The structure 1000 is used to measure a quantum Hall resistance under environment conditions of a temperature of about 1K and a magnetic field.

The base 100 is a means supporting the object 200 providing a measurement value of the quantum Hall resistance and a plurality of conductive lines 300 connected to the object 200. In an embodiment, when the object 200 corresponds to graphene, the base 100 corresponds to a substrate formed of silicon carbide (SiC).

The object 200 should be capable of providing the measurement value of the quantum Hall resistance by the quantum Hall effect in order to realize a quantum resistance standard. As described above, in an embodiment, grapheme which may exhibit the quantum Hall effect in a measurement environment of the quantum Hall resistance with large and relaxed energy gap between Landau levels, that is, at a relatively high temperature and a low magnetic field compared to the existing measurement object.

In an embodiment, graphene is disposed on the base 100 as the object 200. In an example, the object 200 is epitaxial graphene grown on the base 100 which is a substrate formed of silicon carbide, and may be settled on the base 100 by being grown on the base 100 by sublimation of silicon atoms on a surface of silicon carbide in a certain environment.

The plurality of conductive lines 300 are physically connected to the object in one end and electrically connected to a voltage measuring device or a current supplying device on the other end. The plurality of conductive lines 300 are metals having a very low resistance and aligned on the base 100. The plurality of conductive lines 300 includes at least two or more lines, and eight conductive lines 300 may be radially aligned on the base 100 as in the illustrated embodiment.

In an example, the plurality of conductive lines 300 are formed of palladium (Pd) and gold (Au), where palladium is used as a contact metal directly connected to graphene. This is because when palladium and graphene are electrically connected to each other by contact, the resistance appears very low.

The cap 400 serves as a protective film that isolates the object 200 from external air and blocks contact with external air, particularly, moisture or oxygen. Accordingly, a change in the quantum Hall resistance of the object 200 due to moisture or oxygen is prevented, and stability of the object 200 in the quantum Hall resistance measurement is maintained for a long time.

The cap 400 includes a concave portion 410 recessed in a predetermined area 401a of one surface 401 and a flat area 401b excluding the predetermined area 401a on one surface where the concave portion is formed. When the cap 400 is disposed on the base 100 to accommodate the object 200 in the concave portion 410, the adhesive layer 500 is interposed between the flat area 401b and the base 100.

In an embodiment, the cap 400 is formed of glass. That is, the cap 400 is a glass cover.

In addition, in an embodiment, the adhesive layer 500 is formed of epoxy. In the illustrated embodiment, when the cap 400 covers the graphene and is disposed on the base 100, the adhesive layer 500 is interposed so that penetration of oxygen or water molecules into a space including the inside of the concave portion 410 and the base on which the graphene is placed is blocked.

In order to completely block oxygen or water molecules, because even small holes through which oxygen or water molecules may enter and exit are not allowed, the adhesive layer 500 is formed over the entire flat area 401b of the one surface 401 of the cap 400. The size of an area where the adhesive layer is formed, that is, the flat area 401b, may be formed as wide as possible in consideration of penetration possibility, the size of the base, and resistance according to lengths of the plurality of conductive lines.

In addition, when the temperature falls to a cryogenic temperature for measurement of the quantum Hall resistance, thermal stress may occur because thermal expansion coefficients of the cap, the base, and the adhesive layer formed of different materials are different from each other. This causes a crack through which water molecules or oxygen molecules may penetrate into the object 200. When the thickness of the adhesive layer 500 is thickly formed by using a large amount of epoxy, cracks frequently occur during cooling. Accordingly, the adhesive layer 500 is formed to a thickness such that no crack occurs due to the temperature change by controlling the amount of epoxy.

FIG. 3 is a flowchart of a method of manufacturing an encapsulated structure for a quantum resistance standard according to an embodiment of the present invention.

Referring to FIG. 3, the method of manufacturing the encapsulated structure for the quantum resistance standard according to an embodiment of the present invention includes steps of growing graphene on a base, forming a conductive line, and adhering a cap.

In an embodiment, graphene is used as an object for measuring a quantum Hall resistance due to the quantum Hall effect for realizing the quantum resistance standard. As the object for measuring the quantum Hall resistance, graphene is grown on a base formed of silicon carbide. Graphene is grown on the base heated to 1600°C under a gas pressure of 750 Torr argon by sublimation of silicon atoms on a surface of silicon carbide. The quality of the grown graphene was evaluated by atomic force microscopy (AFM) and scanning probe Raman spectroscopy.

Next, a plurality of conductive lines connected to the graphene are formed on the base to measure the quantum Hall resistance of the graphene. One end of the plurality of conductive lines is directly connected to the graphene, and the other end of the plurality of conductive lines is disposed near corners of the base. The plurality of conductive lines extend from one end to the other end, and are formed of palladium (Pd) and gold (Au).

A structure in which the graphene and the plurality of radially extending conductive lines are formed on the base is annealed in a vacuum furnace at 500° C for about 30 minutes. Through an annealing step, organic residues present in the structure are removed while the structure is manufactured, and the graphene exhibits a quantum Hall phenomenon in a lower magnetic field.

Next, in order to prevent the graphene from being decomposed by oxygen or moisture, a cap for isolating the graphene from external air is adhered to the base. The cap is a cover formed of glass, a concave portion is formed to accommodate the graphene in a lower surface, and an area of the lower surface is flat except for an area where the concave portion is formed.

When the graphene is accommodated in the concave portion of the cap, an adhesive layer is interposed between the flat area of the lower surface of the cap and an upper surface of the base. The adhesive layer is formed as, for example, an epoxy adhesive. By controlling an amount of epoxy when the cap is adhered to the base, a crack due to a thermal stress difference according to materials between the cap, the base, and the adhesive layer is prevented at a temperature change over 300°C for measurement of the quantum Hall resistance measurement. Crack prevention ensures long-term stability of measurement of the quantum Hall resistance of graphene.

Finally, the measurement stability of the encapsulated structure is evaluated by exposing the encapsulated structure to air with a relative humidity of 90% for 24 hours. It was confirmed that the encapsulated structure hardly changed its electrical properties despite exposure to high humidity. A quantum Hall resistance value provided by graphene in a magnetic field equal to or greater than 8T was the same before and after exposure to humidity within a measurement uncertainty of about $3 \times 10^{-9}$.

[Description of reference numerals]

| | |
|---|---|
| 1000 | encapsulated structure for quantum resistance standard |
| 100 | base |
| 200 | object |
| 300 | conductive line |
| 400 | cap |
| 500 | adhesive layer |

**Claims**

1. An encapsulated structure for a quantum resistance standard comprising:

   a base;
   an object disposed on the base and providing a measurement value of the quantum Hall resistance;
   two or more conductive lines connected to the object on one end; and
   a cap isolating the object from outside air.

2. The encapsulated structure for the quantum resistance standard of claim 1,
   wherein the object includes graphene.

3. The encapsulated structure for the quantum resistance standard of claim 2,
   wherein the graphene corresponds to epitaxial graphene grown on the base.

4. The encapsulated structure for the quantum resistance standard of claim 1,

> wherein the cap includes a concave portion recessed in a certain area of one surface and a flat area of the one surface except for the certain area in which the concave portion is formed, and an adhesive layer is interposed between the flat area and the base when the object is accommodated in the concave portion.

5. The encapsulated structure for the quantum resistance standard of claim 4,
   wherein the cap is formed of glass.

6. The encapsulated structure for the quantum resistance standard of claim 4,
   wherein the adhesive layer is formed of epoxy.

FIG. 1

FIG. 2

FIG. 3

| STEP OF GROWING GRAPHENE ON BASE |
| STEP OF FORMING CONDUCTIVE LINE |
| STEP OF ADHERING CAP |

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/102807 A1 (ECKINGER MARKUS [DE] ET AL) 16 April 2015 (2015-04-16) * paragraphs [0002], [0023], [0026], [0059], [0090] – paragraph [0095]; figures 1I,1J,8A–8D * | 1-6 | INV. G01R35/00 H01L23/08 |
| X | WO 2020/180977 A1 (UNIV MARYLAND [US] ET AL.) 10 September 2020 (2020-09-10) * paragraphs [0003], [0018], [0043], [0046], [0069], [0077], [0102], [0106]; figures 1,3A,5,6A,7A,8 * | 1-6 | ADD. G01R1/20 G01R3/00 G01R15/20 H01L43/14 |
| X | HANS HE ET AL: "Polymer-encapsulated molecular doped epigraphene for quantum resistance metrology", METROLOGIA, INSTITUTE OF PHYSICS PUBLISHING, BRISTOL, GB, vol. 56, no. 4, 28 June 2019 (2019-06-28), page 45004, XP020341631, ISSN: 0026-1394, DOI: 10.1088/1681-7575/AB2807 [retrieved on 2019-06-28] * page 2 – page 5; figures 1-3 * | 1-6 | |
| A | JARRETT DEAN G ET AL: "Transport of NIST Graphene Quantized Hall Devices and Comparison with AIST Gallium-Arsenide Quantized Hall Devices", 2018 CONFERENCE ON PRECISION ELECTROMAGNETIC MEASUREMENTS (CPEM 2018), IEEE, 8 July 2018 (2018-07-08), pages 1-2, XP033424385, DOI: 10.1109/CPEM.2018.8501079 [retrieved on 2018-10-19] * figure 1 * | 4-6 | TECHNICAL FIELDS SEARCHED (IPC) G01R H02N H01L |

-/--

The present search report has been drawn up for all claims

| Place of search | Date of completion of the search | Examiner |
|---|---|---|
| Munich | 12 July 2022 | Hof, Klaus-Dieter |

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/050227 A1 (PETERSEN KURT EDWARD [US] ET AL) 28 February 2013 (2013-02-28) * paragraph [0132] – paragraph [0133]; figures 9,10A,10B * | 4-6 | |
| A | US 2020/028031 A1 (MATSUI HARUNOBU [JP] ET AL) 23 January 2020 (2020-01-23) * paragraph [0048] – paragraph [0050]; figures 3,4 * | 4-6 | |

TECHNICAL FIELDS
SEARCHED          (IPC)

The present search report has been drawn up for all claims

| Place of search | Date of completion of the search | Examiner |
|---|---|---|
| Munich | 12 July 2022 | Hof, Klaus-Dieter |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

EP 4 047 381 A1

## ANNEX TO THE EUROPEAN SEARCH REPORT
## ON EUROPEAN PATENT APPLICATION NO.

EP 22 15 6496

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2022

| Patent document cited in search report | | Publication date | Patent family member(s) | | Publication date |
|---|---|---|---|---|---|
| US 2015102807 | A1 | 16-04-2015 | CN | 104576917 A | 29-04-2015 |
| | | | DE | 102014115071 A1 | 16-04-2015 |
| | | | US | 2015102807 A1 | 16-04-2015 |
| WO 2020180977 | A1 | 10-09-2020 | US | 2022146597 A1 | 12-05-2022 |
| | | | WO | 2020180977 A1 | 10-09-2020 |
| US 2013050227 | A1 | 28-02-2013 | TW | 201323316 A | 16-06-2013 |
| | | | US | 2013050227 A1 | 28-02-2013 |
| | | | WO | 2013032725 A2 | 07-03-2013 |
| US 2020028031 | A1 | 23-01-2020 | CN | 110752188 A | 04-02-2020 |
| | | | EP | 3599414 A1 | 29-01-2020 |
| | | | JP | 2020021937 A | 06-02-2020 |
| | | | KR | 20200011021 A | 31-01-2020 |
| | | | TW | 202019844 A | 01-06-2020 |
| | | | US | 2020028031 A1 | 23-01-2020 |

EPO FORM P0459

For more details about this annex : see Official Journal of the European Patent Office, No. 12/82